(19) Europäisches Patentamt / European Patent Office / Office européen des brevets

(11) **EP 1 817 791 B1**

(12) **EUROPEAN PATENT SPECIFICATION**

(45) Date of publication and mention
of the grant of the patent:
**20.03.2013 Bulletin 2013/12**

(21) Application number: **05811023.0**

(22) Date of filing: **15.11.2005**

(51) Int Cl.:
***H01L 21/67*** *(2006.01)*

(86) International application number:
**PCT/EP2005/055979**

(87) International publication number:
**WO 2006/056543 (01.06.2006 Gazette 2006/22)**

(54) **APPARATUS AND METHOD FOR WET TREATMENT OF WAFERS**

VORRICHTUNG UND VERFAHREN ZUR NASSBEHANDLUNG VON WAFERN

DISPOSITIF ET PROCEDE POUR LE TRAITEMENT HUMIDE DE TRANCHES

(84) Designated Contracting States:
**AT BE BG CH CY CZ DE DK EE ES FI FR GB GR HU IE IS IT LI LT LU LV MC NL PL PT RO SE SI SK TR**

(30) Priority: **23.11.2004 AT 19682004**

(43) Date of publication of application:
**15.08.2007 Bulletin 2007/33**

(73) Proprietor: **Lam Research AG**
**9500 Villach (AT)**

(72) Inventor: **OKORN-SCHMIDT, Harald**
**A-9020 Klagenfurt (AT)**

(74) Representative: **Kontrus, Gerhard**
**SEZ-Strasse 1**
**9500 Villach (AT)**

(56) References cited:
**WO-A-03/058686**   **US-A- 4 401 131**
**US-A- 4 544 446**   **US-A- 5 979 475**
**US-A1- 2004 149 322**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The invention relates to a device for wet treatment of disk-like substrates comprising a first plate with a size and shape being able to overlap a disk-like substrate to be treated holding means for holding a disk-like substrate parallel to said first plate in a distance of 0.2 to 5 mm rotating means for rotating the disk-like substrate about a rotation axis substantially perpendicular to said first plate. First dispensing means are provided for introducing fluid into a first gap between said first plate and a disk-like substrate when being treated. If in the following the term wafer is used such disk-like substrates are meant.

Such a device will mainly be used to clean particles off the wafer surface but can also be used to clean contamination of ionic or organic nature. After the cleaning step various etching and passivation steps may be carried out.

US 4401131 A1 discloses a wafer-cleaning device, wherein the wafer is held by a vacuum spin chuck 25 and rotated. Simultaneously cleaning liquid is supplied between the wafer and the transducer-plate through a central opening in the transducer plate.

US 5979475 A1 discloses a wafer-cleaning device comprising two parallel plates optionally having an ultrasonic vibrator for treating both sides of a wafer sandwiched there between. The wafer floats on liquid cushions generated by liquid introduced through central openings of each plate. The wafer is not held by any further element and is therefore allowed to rotate freely.

Both devices have the disadvantage that the centre of the wafer may be poorly cleaned because it is hardly agitated by ultrasonic (if used) due to shielding through the fluid inlet, and the liquid does not flow across the wafer parallel to the wafer surface. Flowing across the wafer is helpful to transport loosened particles away from the wafer surface no matter whether ultrasonic is used or not.

Therefore investigations have been made with an eccentric liquid supply. Such eccentric liquid supply however leads to the disadvantage that it might happen that liquid introduced to the dry gap does not properly wet the centre of the wafer or the drying of the wafer might become a problem due to non-radial conditions.

It is an object of the invention to simultaneously solve the problems of wetting the centre of the wafer and properly cleaning the centre of the wafer.

Other objects of the invention are to further enhance cleaning uniformity and cleaning efficiency.

The invention meets the objects by providing a device for wet treatment of disk-like substrates as claimed in claim 1.

A plate may have the shape of any kind of body, which has a flat surface serving as a plate. Such bodies may be a cone, a frustum, a cylinder, a circular disk or similar. The plate may be made of polymer material such as poly tetra fluor ethylene (e.g. Teflon™), metal with coated surfaces or any other material inert to the treating fluids used or with an appropriate coating.

The dispensing opening may comprise one dispense nozzle or a plurality of dispense nozzles, which may be arranged parallel or coaxial.

It is advantageous if said first dispensing opening when being in said first position includes the rotation axis whereas it does not include said rotation axis in said second position.

The current invention brings the advantage that within one and the same device liquid can be introduced selectively either in the centre or off the centre of a rotational movement of a disk-like substrate when being treated. For instance it may be advantageous on the one hand to clean a disk-like substrate when liquid flows across the central area of a disk-like substrate without being disturbed by any element such as a dispensing opening. On the other hand it may be useful to dry the disk-like substrate thereafter by introducing drying gas to the rotation centre of the disk like substrate.

Preferably said shifting means are for changing the distance d of said first dispensing opening to the rotation axis from d1 to d2, wherein d1 is in the range of 0 to 1mm and d2 is in the range of 3 to 20mm. Such shifting means comprises driving elements such as a belt drive, gear drive, pneumatic cylinder or ball spindle. The shifting means may either shift said first plate or may shift the rotatable holding means i.e. the rotation axis may be shifted.

The device further comprises a second plate substantially parallel to said first plate so that a chamber is provided by the two plates in order to receive a disk-like substrate to be treated therein.

The device further comprises second dispensing means for introducing fluid into a second gap between said second plate and a disk-like substrate when being treated. Such fluid may be gas or liquid. The second dispensing means and the size of the second gap is configured so that the second dispensing means, when delivering liquid, are able to completely fill the second gap with such liquid.

Furthermore the device comprises at least one vibrating element acoustically coupled to at least said first plate. The at least one vibrating element may be a piezoelectric transducer. Such piezoelectric transducers shall be bonded to a reasonable resonator typically made of rigid material like quartz, stainless steel, aluminum, glass or sapphire, SiC or BN. For bonding a transducer to the resonator a rigid medium such as glass or quartz may be used. If the plate's material is not a rigid material the resonator could be coupled to the plate through an intermediate medium like water.

Advantageously said holding means and said second plate are coupled to each other to form a rotatable holding unit (a spin chuck).

A second aspect of the invention is a method for wet treatment of a disk-like substrate according to claim 4.

Advantageously said first dispensing opening when being in said first position includes the rotation axis whereas it does not include said rotation axis in said second position. The first position can be used for filing liquid into the first gap, rinsing and drying the disk-like substrate. The second position may be used when cleaning liquid is applied e.g. during ultrasonic treatment.

It is useful if one treatment step is carried out when said first dispensing opening is at the first position and another treatment step is carried out when said first dispensing opening is at the second position.

Advantageously a first treatment step is carried out when said first dispensing opening is at the first position and a subsequent treatment step is carried out when said first dispensing opening is at the second position.

In the method ultrasonic energy is applied to the disk-like substrate during at least a time sequence during the disk-like substrate treatment.

Preferably at least part of the time, during applying ultrasonic energy, the first dispense opening is set off the rotation axis, which means that the dispense opening does not include the rotation axis.

For uniformity purposes it might be useful to shift the position of said first dispensing opening with respect to the rotation axis during at least a time sequence when ultrasonic energy is applied to the substrate.

This can be done periodically with a given frequency (shifting frequency). It is preferred if such frequency is not an integer multiple of the used rotation frequency or if the shifting frequency is selected at least 5 times smaller than the rotation frequency (e.g. rotation frequency = 60 min$^{-1}$; shifting frequency = 7 min$^{-1}$).

Further details of the invention will become apparent from the following drawings and the detailed description referring thereto.

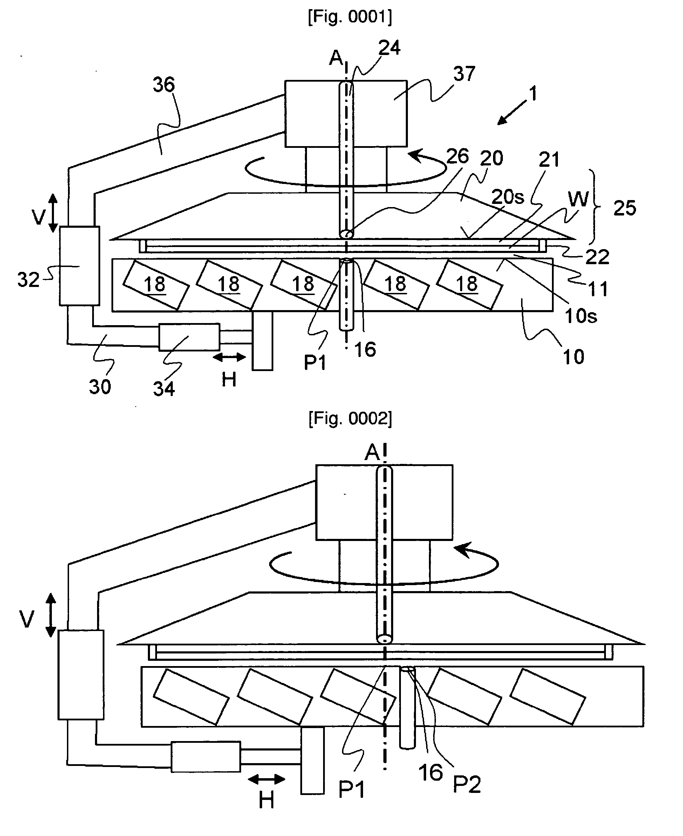

Fig.1 shows a schematic drawing of a device 1 according to one embodiment of the invention.

A spin chuck 25 for rotatable holding a wafer W is mounted in a hanging position in order to hold the wafer W below it. Spin chuck 25 comprises gripping pins 22 for securely holding the wafer W at the wafer's edge. The gripping pins can be either eccentrically moved or tilted for gripping and releasing the wafer W. The mechanism (not shown) for moving gripping pins can be similar to the mechanism disclosed in US4903717. The spin chuck 25 further comprises a chuck plate 20 with a plane surface 20s parallel to a wafer when being treated and covering the wafer. The plane 20s has a dispensing opening 26 in its centre for receiving a fluid nozzle. The spin chuck 25 is mounted by a coaxial hollow shaft to a hollow shaft motor 37. The rotation axis A of shaft and spin chuck 25, about which the spin chuck 25 is rotated, is perpendicular to the plane surface 20. Within the hollow shaft a tube 24 is inserted coaxially. The tube is welded to the plane 20s at its central dispensing opening. The tube may either serve as housing for different fluid pipes (e.g. for liquid and/or gas) or may serve as fluid pipe itself. For connecting tube 24 to a tubing system a rotating union (not shown) is used.

A lower plate 10 is arranged below the spin chuck 25. The lower plate 10 has a plane surface 10s facing the spin chuck 25 and being substantially parallel to the plane surface 20s of the spin chuck 25. In other words parallel planes 10s and 20s form a chamber, which is circumferential open to ambient. The space between the two planes is provided for the wafer to be treated. The wafer then will be sandwiched between planes 10s and 20s. A borehole in the lower plate 10 opens in a central dispense opening 16 being located in the plane 10s. The borehole may either serve as housing for different fluid pipes (e.g. for liquid and/or gas) or may serve as fluid pipe itself. A plurality of ultrasonic transducers is glued to the lower plate 10, which then serves as a resonator plate. Through lower plate 10 ultrasonic energy is then transmitted from transducers to the medium and further more to the wafer surface.

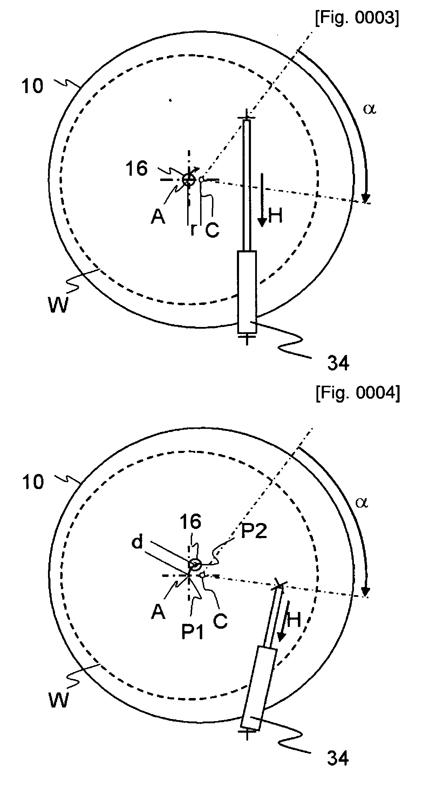

The bearing of lower plate 10 is arranged so that lower plate 10 can be moved substantially parallel to the plane 10s. Such movement can either be a linear movement or a turning about a centre, which is eccentric with respect to the rotation axis A (further described with reference to Fig. 3 and Fig. 4). The purpose of this movement (illustrated by arrow H) is to shift the dispense opening 16 from a first position P1, where axis A goes through the dispense opening 16, to a second position P2 (Fig. 2), where the dispense opening is set off the rotation axis A. The movement is carried out by a linear motor 34 (e.g. a pneumatic cylinder).

Lower plate 10 is connected to the spin chuck 25 via frame elements 30 and 36. In order to change the distance between wafer W and the lower plate 10 a lifting motor 34 lifts the spin chuck 25.

The lower plate 10 is circumferentially surrounded by an annular liquid collector (not shown), which may also be called cup, bowl or splashguard respectively. The lower plate 10 is sealed against the liquid collector with an O-ring seal (not shown) or the lower plate 10 is part of the liquid collector or welded thereto. The liquid collector comprises an annular duct for collecting liquid, which is flung of the wafer during wet treatment and the liquid is drained through an opening near the bottom of the annular duct. The liquid collector further comprises an annular gas suction nozzle directed inwardly above the annular duct for receiving ambient gas and mist deriving from wet treatment. The inner diameter of the upper part of the liquid collector 10 is larger than the outer diameter of the spin chuck 25 so that the first plate can be inserted into the liquid collector leaving a circumferential gap of 0.2 - 5.0 mm. The gap shall be small enough to seal the wafer against the ambient during treatment but big enough to avoid friction between the spin chuck 25 and the liquid collector during the spin chuck 25 being rotated. Furthermore the liquid collector shall allow the horizontal shift H without colliding with the spin chuck 25.

Following a cleaning method according to one embodiment of the invention is described with reference to the above-described device shown in Fig. 1 and Fig. 2.

A semiconductor wafer shall be cleaned during integrated circuit manufacturing.

The device is opened by lifting (V) the spin chuck 25 from the lower plate 10 to open so that the gap between the plate of the spin chuck 25 and the lower plate has a distance of 20mm. The gripping pins 22 are opened and the wafer is entered into the device. Thereafter the gripping pins 22 are closed to securely hold the wafer and the spin chuck 25 is lowered to bring wafer W in close proximity to the lower plate 10. The device side of the wafer, which carries the integrated circuits faces the lower plate 10. The distance of the wafer surface, which faces the lower plate, to the upper surface 10s of the lower plate is preferably selected as 1mm. The lower plate 10 is in a position so that the dispense opening 16 of the lower plate incorporates the rotation axis A of the spin chuck 25. In other words the dispense opening 16 of the lower plate 10 is substantially in the centre with respect of the rotational movement of the spin chuck 25. A cleaning fluid (e.g. SC2, a mixture of water, hydrogen peroxide, hydrochloric acid), which is entered through the dispense opening 16, fills the lower gap 11 completely and thereby wets the lower wafer surface as well as the surface 10s of the lower plate 10. Simultaneously the upper gap 21 between the wafer and the plate 20 of the spin chuck 25 is filled through dispense opening 26.

When both gaps 11, 21 are filled the lower plate 10 is horizontally shifted by 15mm (H) and the centre of the dispense opening 16 is moved to position P2 (Fig. 2). Thereafter transducers 18 are switched on (1500 kHz) and the spin chuck 25 is rotated at a spin speed of 20rpm. Meanwhile volume flows of liquids through dispense openings 16 and 26 are kept constant each at 0.1 litre by minute. Liquid flowing through lower gap 11 and upper gap 21 together flow into the liquid collector and are drained or recycled.

As the dispense opening 16 is now set off the rotational centre P1 ultrasonic energy is uniformly transmitted even to the centre of the wafer because the centre is covered by the resonator plate 10.

After ultrasonic cleaning step (ultrasonic transducers are switched off) the lower plate 10 is shifted back so that rotational axis again goes through dispense opening 16 (position P1). Cleaning liquid on both wafer sides may thereafter either be displaced by gas or liquid. If gas is used for instance it can be nitrogen, 2-propanol vapour, water vapour or a mixture thereof. A mixture of nitrogen and 2-propanol vapour is preferred. Displacing cleaning liquid with gas brings the advantage that the cleaning liquid can be recycled without any significant loss. Thereafter both wafer sides are rinsed with deionized water (DI-water).

If cleaning liquid is directly displaced by a rinsing liquid (such as DI-water), intermediate liquid, which is a mixture of cleaning liquid and rinsing liquid, cannot be recycled and thus has to be run into drain.

No matter whether cleaning liquid is directly displaced with rinsing liquid or with gas the rinsing liquid is displaced by drying gas (e.g. dry air, nitrogen, 2-propanol vapour or a mixture thereof). During applying drying gas spin chuck 25 may accelerated up to 100 rpm in order to further enhance drying efficiency.

After drying the device 1 is opened again and the wafer is picked from the spin chuck 25.

Fig. 3 and Fig. 4 show schematic views from below of an alternative mechanism for shifting the position of said dispensing opening 16 from a first position P1 to a second position P2.

The lower plate 10 is circle shaped, rotatable mounted concentric with the surrounding collector and sealed against said collector. The dispense opening 16 is located eccentric to the centre C of the lower plate 10 but in the rotational centre of the spin chuck which rotates about axis A. W indicates the wafer. When the lower plate 10 is turned about its rotational centre C by an angle $\alpha$ the dispense opening moves from the first position P1 to a second position P2. The turning is driven by pneumatic cylinder 34. The distance d from P1 to P2 is depending on angle $\alpha$ and offset r of P1 to the rotational centre C of the lower plate 10 and follows the equation 1.

$$(\text{equ. } 1)\ d = 2r \sin \alpha/2$$

If r is 15 mm and $\alpha$ is 50° d will be about 13 mm.

## Claims

1. Device for wet treatment of disk-like substrates comprising

   - a first plate (10) with a size and shape being able to overlap a disk-like substrate (w) to be treated
   - holding means (22) for holding the disk-like substrate (W) parallel to said first plate in a distance of 0.2 to 5 mm
   - rotating means (37) for rotating the disk-like substrate (W) about a rotation axis (A) substantially perpendicular to said first plate
   - first dispensing means with a first dispensing opening (16) in the first gap for introducing fluid into a first gap (11) between said first plate (10) and the disk-like substrate (W) when being treated
   - at least one vibrating element (18) acoustically coupled to at least said first plate (10)
   - a second plate (20) substantially parallel to said first plate (10) so that a chamber is provided by the two plates in order to receive the disk-like substrate to be treated therein, and

- second dispensing means (24) for introducing fluid into a second gap between said second plate and the disk-like substrate when being treated **characterized in that** the device further comprises:

- shifting means (34) for shifting the position of said first dispensing opening (16) together with the first plate (10) with respect to the rotation axis (A) from a first position (P1) to a second position (P2) wherein the distance of said first position (P1) to the rotation axis (A) is smaller than the distance of said second position (P2) to the rotation axis (A).

2. Device according to claim 1 wherein said first dispensing opening (16) when being in said first position (P1) includes the rotation axis whereas it does not include said rotation axis (A) in said second position (P2).

3. Device according to claim 1 wherein said holding means (22) and said second plate (20) are coupled to each other to form a rotatable holding unit.

4. Method for wet treatment of a disk-like substrate (w)

- placing the disk-like substrate to be treated parallel to a first plate in a distance of 0.2 to 5 mm
- rotating the disk-like substrate (W) about a rotation axis (A) substantially perpendicular to said first plate
- inserting a first liquid through a first dispensing opening (16) into said first gap thereby substantially completely filling said first gap
- providing a second plate (20) substantially parallel to said first plate (10) so that a chamber is provided by the two plates in order to receive the disk-like substrate to be treated therein,
- introducing fluid through second dispensing means (24) into a second gap between said second plate and the disk-like substrate
- applying ultrasonic energy to the disk-like substrate during at least a time sequence during the disk-like substrate treatment **characterized in that** the method further comprises :
- shifting the position of said first dispensing opening (16) together with the first plate (10) with respect to the rotation axis (A) from a first position (P1) to a second position (P2) wherein the distance of said first position (P1) to the rotation axis (A) is smaller than the distance of said second position (P2) to the rotation axis (A).

5. Method according to claim 4 wherein said first dispensing opening (16) when being in said first position (P1) includes the rotation axis whereas it does not include said rotation axis (A) in said second position (P2).

6. Method according to claim 4 wherein one treatment step is carried out when said first dispensing opening is at the first position (P1) and another treatment step is carried out when said first dispensing opening is at the second position (P2).

7. Method according to claim 4 wherein a first treatment step is carried out when said first dispensing opening is at the first position (P1) and a subsequent treatment step is carried out when said first dispensing opening is at the second position (P2).

8. Method according to claim 4 wherein the position of said first dispensing opening (16) is shifted with respect to the rotation axis (A) during at least a time sequence when ultrasonic energy is applied to the substrate.

**Patentansprüche**

1. Einrichtung zur Nassbehandlung von scheibenförmigen Substraten, umfassend:

- eine erste Platte (10) mit einer Größe und Form, die geeignet sind, ein scheibenartiges zu behandelndes Substrat (W) zu überlappen;
- Haltemittel (22) zum Halten des scheibenförmigen Substrats (W) parallel zu der ersten Platte in einem Abstand von 0,2 bis 5 mm;
- Drehmittel (37) zum Drehen des scheibenförmigen Substrats (W) um eine Drehachse (A) im Wesentlichen senkrecht zu der ersten Platte;
- erste Abgabemittel mit einer ersten Abgabeöffnung (16) im ersten Spalt zum Einbringen von Fluid in einen ersten Spalt (11) zwischen der ersten Platte (10) und dem scheibenartigen Substrat (W), wenn dieses behandelt wird;
- mindestens ein Schwingelement (18), das mindestens mit der ersten Platte (10) akustisch gekoppelt ist;
- eine zweite Platte (20), die im Wesentlichen parallel zu der ersten Platte (10) ist, so dass durch die beiden Platten eine Kammer geschaffen wird, um das scheibenförmige Substrat aufzunehmen, um darin behandelt zu werden; und
- zweite Abgabemittel (24) zum Einbringen von Fluid in einen zweiten Spalt zwischen der zweiten Platte und dem scheibenförmigen Substrat, wenn dieses behandelt wird, **dadurch gekennzeichnet, dass** die Vorrichtung ferner umfasst:
- Verschiebungsmittel (34) zum Verschieben der Position der ersten Abgabeöffnung (16) zusammen mit der ersten Platte (10) in Bezug auf die Drehachse (A) von einer ersten Position (P1) an eine zweite Position (P2), wobei der Abstand von der ersten Position (P1) zur Drehachse (A) kleiner ist als der Abstand von der zweiten Position (P2) zur Drehachse (A).

2. Vorrichtung nach Anspruch 1, wobei die erste Abgabeöffnung (16) die Drehachse einschließt, wenn sie sich in der ersten Position (P1) befindet, während sie in der zweiten Position (P2) die Drehachse (A) nicht einschließt.

3. Vorrichtung nach Anspruch 1, wobei die Haltemittel (22) und die zweite Platte (20) miteinander gekoppelt sind, um eine drehbare Halteeinheit zu bilden.

4. Verfahren zur Nasshandlung eines scheibenförmigen Substrats (W), umfassend:

   - Platzieren des zu behandelnden scheibenförmigen Substrats parallel zu einer ersten Platte in einem Abstand von 0,2 bis 5 mm;
   - Drehen des scheibenförmigen Substrats (W) um eine Drehachse (A) im Wesentlichen senkrecht zu der ersten Platte;
   - Einbringen einer ersten Flüssigkeit durch eine erste Abgabeöffnung (16) in den ersten Spalt, wodurch der erste Spalt im Wesentlichen vollständig gefüllt wird;
   - Bereitstellen einer zweiten Platte (20), die im Wesentlichen parallel zu der ersten Platte (10) ist, so dass durch die beiden Platten eine Kammer geschaffen wird, um das scheibenförmige Substrat aufzunehmen, um darin behandelt zu werden;
   - Einbringen von Fluid durch zweite Abgabemittel (24) in einen zweiten Spalt zwischen der zweiten Platte und dem scheibenförmigen Substrat;
   - Anlegen von Ultraschallenergie an das scheibenförmige Substrat während mindestens einer Zeitsequenz während der Behandlung des scheibenförmigen Substrats;
   dadurch gekennzeichnet, dass das Verfahren ferner Folgendes umfasst:
   - Verschieben der Position des ersten Abgabeöffnung (16) zusammen mit der ersten Platte (10) in Bezug auf die Drehachse (A) von einer ersten Position (P1) an eine zweite Position (P2), wobei der Abstand von der ersten Position (P1) zur Drehachse (A) kleiner ist als der Abstand von der zweiten Position (P2) zur Drehachse (A).

5. Verfahren nach Anspruch 4, wobei die erste Abgabeöffnung (16) die Drehachse einschließt, wenn sie sich in der ersten Position (P1) befindet, während sie in der zweiten Position (P2) die Drehachse (A) nicht einschließt.

6. Verfahren nach Anspruch 4, wobei ein Behandlungsschritt durchgeführt wird, wenn die erste Abgabeöffnung an der ersten Position (P1) ist, und ein weiterer Behandlungsschritt durchgeführt wird, wenn die erste Abgabeöffnung an der zweiten Position (P2) ist.

7. Verfahren nach Anspruch 4, wobei ein erster Behandlungsschritt durchgeführt wird, wenn die erste Abgabeöffnung an der ersten Position (P1) ist, und ein nachfolgender Behandlungsschritt durchgeführt wird, wenn die erste Abgabeöffnung an der zweiten Position (P2) ist.

8. Verfahren nach Anspruch 4, wobei die Position der ersten Abgabeöffnung (16) in Bezug auf die Drehachse (A) während wenigstens einer Zeitsequenz, wenn Ultraschallenergie an das Substrat angelegt wird, verschoben ist.

**Revendications**

1. Un dispositif pour un traitement humide de substrats ressemblant à des disques comprenant :

   - une première plaque (10) avec une taille et une forme pouvant chevaucher un substrat ressemblant à un disque (W) à traiter
   - un moyen de support (22) pour soutenir le substrat ressemblant à un disque (W) parallèle à ladite première plaque à une distance de 0,2 à 5 mm.
   - un moyen de rotation (37) pour faire tourner le substrat ressemblant à un disque (W) autour d'un axe de rotation (A) substantiellement perpendiculaire à ladite première plaque
   - un premier moyen de distribution avec une première ouverture de distribution (16) dans le premier espace pour introduire du liquide dans un premier espace (11) entre ladite première plaque (10) et le substrat ressemblant à un disque (W) lorsqu'il est traité
   - au moins un élément de vibration (18) acoustiquement raccordé à au moins ladite première plaque (10)
   - une deuxième plaque (20) substantiellement parallèle à ladite première plaque (10) pour qu'une chambre soit munie des deux plaques afin de recevoir le substrat ressemblant à un disque à traiter, et
   - un deuxième moyen de distribution (24) pour introduire du liquide dans un deuxième espace entre ladite deuxième plaque et le substrat ressemblant à un disque lorsqu'il est traité, **caractérisé en ce que** le dispositif comprend de plus :
   - un moyen de changement (34) pour changer la position de ladite ouverture de distribution (16) avec la première plaque (10) par rapport à l'axe de rotation (A) à partir d'une première position (P1) dans une deuxième position (P2) où la distance de ladite première position (P1) jusqu'à l'axe de rotation (A) est inférieure à la distance de ladite deuxième position (P2) jusqu'à l'axe de rotation (A).

2. Un dispositif selon la revendication 1 où ladite première ouverture de distribution (16) lorsqu'elle est dans ladite première position (P1) inclut l'axe de rotation alors qu'elle n'inclut pas ledit axe de rotation (A) dans ladite deuxième position (P2).

3. Dispositif selon la revendication 1 où ledit moyen de support (22) et ladite deuxième plaque (20) sont raccordés l'un à l'autre pour former une unité de support rotative.

4. Une méthode pour le traitement humide du substrat ressemblant à un disque (W)

   - plaçant le substrat ressemblant à un disque à traiter de façon parallèle à une première plaque à une distance de 0,2 à 5 mm
   - tournant le substrat ressemblant à un disque (W) autour d'un axe de rotation (A) substantiellement perpendiculaire à ladite première plaque
   - insérant un premier liquide au travers d'une première ouverture de distribution (16) dans ledit premier espace, remplissant donc complètement, de manière substantielle, ledit premier espace
   - fournissant une deuxième plaque (20) substantiellement parallèle à ladite première plaque (10) pour qu'une chambre soit munie des deux plaques afin de recevoir le substrat ressemblant à un disque à y traiter,
   - introduisant du liquide au travers d'un deuxième moyen de distribution (24) dans un deuxième espace entre ladite deuxième plaque et le substrat ressemblant à un disque
   - appliquant de l'énergie ultrasonique au substrat ressemblant à un disque pendant au moins une séquence temporelle pendant le traitement du substrat ressemblant au disque **caractérisé en ce que** la méthode comprend de plus :
   - un changement de position de ladite première ouverture de distribution (16) avec la première plaque (10) par rapport à l'axe de rotation (A) à partir d'une première position (P1) dans une deuxième position (P2) où la distance de ladite première position (P1) jusqu'à l'axe de rotation (A) est inférieure à la distance de ladite deuxième position (P2) jusqu'à l'axe de rotation (A).

5. Une méthode selon la revendication 4 où ladite première ouverture de distribution (16) lorsqu'elle est dans ladite première position (P1) inclut l'axe de rotation alors qu'elle n'inclut pas ledit axe de rotation (A) dans ladite deuxième position (P2).

6. Une méthode selon la revendication 4 où une étape de traitement est effectuée lorsque ladite première ouverture de distribution est dans la première position (P1) et une autre étape de traitement est effectuée lorsque ladite première ouverture de distribution est dans la deuxième position (P2).

7. Une méthode selon la revendication 4 où une première étape de traitement est effectuée lorsque ladite première ouverture de distribution est dans la première position (P1) et une étape de traitement suivante est effectuée lorsque ladite première ouverture de distribution est dans la deuxième position (P2).

8. Une méthode selon la revendication 4 où la position de ladite première ouverture de distribution (16) est changée par rapport à l'axe de rotation (A) pendant au moins une séquence temporelle lorsque de l'énergie ultrasonique est appliquée au substrat.

[Fig. 0001]

[Fig. 0002]

[Fig. 0003]

[Fig. 0004]

**EP 1 817 791 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4401131 A1
- US 5979475 A1
- US 4903717 A